# EUROPEAN PATENT APPLICATION

(11) **EP 4 531 515 A1**
(43) Date of publication of application: **02.04.2025**
(21) Application number: 23925596.1
(22) Date of filing: 07.08.2023
(51) Int. Cl.: H10B 80/00, H01L 21/78, H01L 21/283

(54) **SEMICONDUCTOR DEVICE, CHIP AND PREPARATION METHOD THEREFOR, AND STORAGE SYSTEM**

(71) Applicant: Yangtze Memory Technologies Co., Ltd., Wuhan, Hubei 430205 (CN)
(72) Inventor: MO, Ping, Wuhan, Hubei 430205 (CN); CHEN, Peng, Wuhan, Hubei 430205 (CN); XIE, Wei, Wuhan, Hubei 430205 (CN); FANG, Hong, Wuhan, Hubei 430205 (CN); LIU, Lei, Wuhan, Hubei 430205 (CN); XIA, Zhiliang, Wuhan, Hubei 430205 (CN)
(74) Representative: Gramm, Lins & Partner Patent- und Rechtsanwälte PartGmbB
(86) International application number: PCT/CN2023/111492
(87) International publication number: WO 2025/030318

(57) **Abstract**

The present disclosure provides a semiconductor device, a chip and a fabrication method thereof, as well as a memory system. The semiconductor device includes a plurality of cutting lanes, a plurality of dies and a die test structure, and the plurality of dies are defined by the intersection of the plurality of cutting lanes. The plurality of cutting lanes include at least one first cutting lane, a plurality of second cutting lanes and a third cutting lane, wherein the first cutting lanes and the second cutting lanes are disposed in parallel with each other, and the third cutting lane is disposed intersecting the first cutting lanes and the second cutting lanes.

## Description

### TECHNICAL FIELD

The present disclosure generally relates to electronics, and more particularly to a semiconductor device, a chip and a fabrication method thereof, as well as a memory system.

### BACKGROUND

NAND memory device is a non-volatile memory product with low power consumption, light weight and good performance, which has been widely applied in electronic products. NAND device of planar structure has practically reached its limit in scalability. In order to further increase memory capacity and reduce memory cost per bit, 3D NAND memories are proposed. In a 3D NAND memory architecture, memory cells are arranged in multiple levels stacked vertically to achieve a memory architecture in stack.

As the stacked layers become more and more, the cutting process of cutting lanes impacts the strength of device more and more.

### SUMMARY

The present disclosure aims to provide a semiconductor device and a method of fabricating the same so as to reduce the influence on the strength of device by cutting the cutting lanes.

In the first aspect, the present disclosure provides a semiconductor device comprising: a plurality of cutting lanes, comprising at least one first cutting lane, a plurality of second cutting lanes and a third cutting lane, wherein the first cutting lane and the second cutting lanes are disposed in parallel with each other, and the third cutting lane is disposed intersecting the first cutting lane and the second cutting lanes; a plurality of dies defined by the intersection of the plurality of cutting lanes; and a die test structure only located in the first cutting lane, wherein any one first cutting lane is disposed at least adjacent to one of the second cutting lanes.

In some implementations, at least three of the second cutting lanes are arranged between adjacent two of the first cutting lanes.

In some implementations, a number of the second cutting lanes spaced between the adjacent two of the first cutting lanes is equal.

In some implementations, the cutting lane comprises first dielectric layers and second dielectric layers stacked alternatively, and the die test structure penetrates the cutting lanes in a stacking direction of the cutting lanes and comprises third dielectric layers and conductive layers stacked alternatively in the stacking direction.

In some implementations, a thickness of the die test structure is smaller than or equal to a thickness of the cutting lane.

In some implementations, the die test structures with a same thickness are located in a same first cutting lane.

In some implementations, the semiconductor device further comprises: a semiconductor layer; a stack on the semiconductor layer and comprising the third dielectric layers and the conductive layers stacked alternatively in the stacking direction; wherein the cutting lane and the die test structure are located on the semiconductor layer.

In some implementations, the die comprises a memory device and a peripheral circuit bonded with each other, and the die test structure is configured for electric performance test of the memory device, the peripheral circuit or a bonding interface between the memory device and the peripheral circuit.

In some implementations, the plurality of cutting lanes and the plurality of dies constitute a repeating unit, and the repeating unit comprises at least one first cutting lane and the semiconductor device comprises a plurality of the repeating units.

In the second aspect, the present disclosure provides a chip fabricated from the semiconductor device in any one of the above-described implementations, the chip comprising a first cutting face and a second cutting face outside the first cutting face, and the second cutting face has a height smaller than a height of the first cutting face.

In the third aspect, the present disclosure provides a memory system comprising: the chip provided in the above-described implementations; and a controller electrically connected with the chip to control the chip to store data.

In the fourth aspect, the present disclosure provides a fabrication method of a chip comprising: providing a semiconductor device provided with a plurality of cutting lanes, the cutting lanes comprising a first cutting lane, a second cutting lane and a third cutting lane, wherein the first cutting lane and the second cutting lane are disposed in parallel with each other, and the third cutting lane is disposed intersecting the first cutting lane and the second cutting lane, and a die test structure is disposed in the first cutting lane; and cutting the semiconductor device into a plurality of chips along the first cutting lane, the second cutting lane and the third cutting lane.

In some implementations, the cutting the semiconductor device into the plurality of chips along the first cutting lane, the second cutting lane and the third cutting lane comprises: cutting the semiconductor device twice with two different cutting processes, respectively.

In some implementations, the cutting the semiconductor device into a plurality of chips along the first cutting lane, the second cutting lane and the third cutting lane comprises: forming a first groove in the first cutting lane with a first laser to remove a part of the die test structure, wherein a depth of the first groove is smaller than a thickness of the first cutting lane; and cutting mechanically the second cutting lane, the third cutting lane, and the first cutting lane under the first groove to form the plurality of chips.

In some implementations, before cutting the first cutting lane under the first groove, the second cutting lane and the third cutting lane with a blade, the fabrication method of the chip further comprises: forming a second groove in the second cutting lane and forming a third groove in the third cutting lane with a second laser, wherein a depth of the second groove is smaller than a thickness of the second cutting lane, and a depth of the third groove is smaller than a thickness of the third cutting lane; the cutting mechanically the second cutting lane, the third cutting lane and the first cutting lane under the first groove comprises: cutting the first cutting lane under the first groove, the second cutting lane under the second groove and the third cutting lane under the third groove with the blade.

In some implementations, an energy of the second laser is smaller than an energy of the first laser.

The present disclosure provides a semiconductor device, a chip and a fabrication method thereof, as well as a memory system. The semiconductor device includes a plurality of cutting lanes, a plurality of dies and a die test structure, and the plurality of dies are defined by the intersection of the plurality of cutting lanes. The plurality of cutting lanes include at least one first cutting lane, a plurality of second cutting lanes and a third cutting lane, wherein the first cutting lane and the second cutting lanes are disposed in parallel with each other, and the third cutting lane is disposed intersecting the first cutting lane and the second cutting lanes. The die test structure is only located in the first cutting lane, and any one first cutting lane is disposed at least adjacent to one of the second cutting lanes. By concentrating the die test structure in the first cutting lane rather than in the second cutting lane and the third cutting lane, it is possible to use different laser cutting conditions for the cutting lane with the die test structure and the cutting lane without the die test structure while performing cutting process such that the laser cutting depth of the second cutting lane and the third cutting lane is reduced, thereby improving the strength of the device.

### BRIEF DESCRIPTION OF DRAWINGS

Technical solutions and other beneficial effects of the present disclosure will become apparent from the following detailed description of implementations of the present disclosure in connection with the accompanying drawings.
Fig. 1 is a structure diagram of a semiconductor device provided by some implementations of the present disclosure;
Fig. 2 is a structure diagram of a semiconductor device provided by some implementations of the present disclosure;
Fig. 3 is a sectional structure diagram of a semiconductor device in Fig. 1 provided by some implementations of the present disclosure along A-A1;
Fig. 4 is a flow chart of a fabrication method of a chip provided by some implementations of the present disclosure;
Figs. 5a-5c are structure diagrams of a chip in the fabrication process provided by some implementations of the present disclosure; and
Fig. 6 is a structure diagram of a memory system provided by some implementations of the present disclosure.

### DETAILED DESCRIPTION

The technical solutions in implementations of the present disclosure will be described clearly and fully below in connection with accompanying drawings in implementations of the present disclosure. Obviously, the described implementations are only a part of implementations of the present disclosure rather than all of them. All other implementations obtained by those skilled in the art based on the implementations of the present disclosure without any creative works fall within the scope of the present disclosure.

It should be understood that terms "first", "second" etc. may be used to describe various components herein, but are not intended to limit them. These terms are only used to partition one component from another. For example, a "first component" may be referred to as a "second component" and likewise a "second component" may be referred to as a "first component" without departing from the scope of the present disclosure.

It should be understood that when a component is described to be "on" or "connected to" another component, it can be directly on or connected to the another component or there may be intervening components. Other terms for describing relationship among components should be interpreted similarly.

As used herein, the term "layer" refers to a part of material including a region with a thickness. A layer can extend over the entirety of an underlying or overlying structure or may have an extent less than the extent of an underlying or overlying structure. Furthermore, a layer may be a region of uniform or non-uniform continuous structure with a thickness smaller than that of a continuous structure. For example, a layer may be between the top surface and bottom surface of a continuous structure or between any group of horizontal planes at the top surface and the bottom surface. A layer may extend horizontally, vertically and/or along a conical surface. The substrate may be a layer that may include one or more layers therein and/or may have one or more layers on, over and/or under it. A layer can include multiple layers. For example, an interconnect layer can include one or more conductive layers and contact layers (in which contacts, interconnect lines and/or vertical interconnect accesses (VIA) are formed) and one or more dielectric layers.

It is to be noted that the drawings provided in the implementations of the present disclosure only illustrates the basic conception of the present disclosure schematically. Although only the components related to this disclosure are shown in the drawing, and not drawn according to the number, shape and size of components in actual implementation, the type, number and proportion of components in actual implementation can be changed at will, and the layout of components may be more complicated.

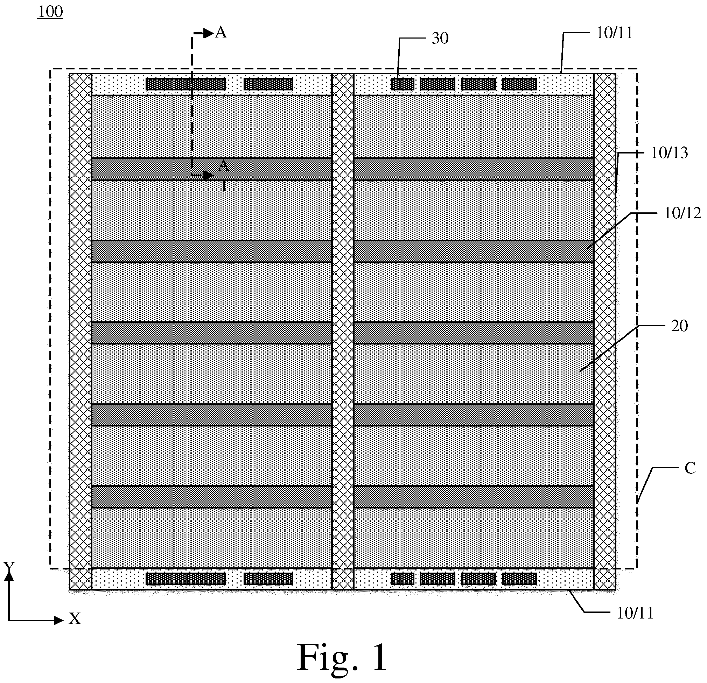

Referring to Fig. 1, Fig. 1 is a structure diagram of a semiconductor device provided by some implementations of the present disclosure. The semiconductor device 100 may be a wafer, which may be cut to form a plurality of chips, such as a 3D memory. The 3D memory may be applied in communication products, consumer electronic products, automobile products, aerospace products, artificial intelligence products or big data, etc. Consumer electronic products include, but not limited to mobile phones, computers, tablet computers, cameras, smart glasses or game products, etc.

The semiconductor device 100 includes a plurality of cutting lanes 10, a plurality of dies 20 and a die test structure 30, in which the plurality of dies 20 are defined by the intersection of the plurality of cutting lanes 10. The plurality of cutting lanes 10 include at least one first cutting lane 11, a plurality of second cutting lanes 12 and a third cutting lane 13 in which the first cutting lane 11 and the second cutting lanes 12 are disposed in parallel with each other, and the third cutting lane 13 is disposed intersecting the first cutting lane 11 and the second cutting lanes 12. For example, both the first cutting lane 11 and the second cutting lanes 12 may be disposed in the X direction, and the third cutting lane 13 may be disposed in the Y direction. A plurality of dies 20 are defined by the intersection of the first cutting lane 11, the second cutting lanes 12 and the third cutting lane 13. That is, the dies 20 are located in regions defined by the intersection of the plurality of cutting lanes 10. For example, one die 20 is disposed in one of the regions. The one die 20 referred to herein may include an integrated circuit block defined by the cutting lanes on the wafer but not cut yet.

The die test structure 30 is only located in the first cutting lane 11, and any one first cutting lane 11 is disposed at least adjacent to one of the second cutting lanes 12. That is, the die test structure 30 is concentrated in the first cutting lane 11 and not disposed in the second cutting lanes 12 and the third cutting lane 13. Also, the second cutting lane 12 is disposed besides each first cutting lane 11. For example, one, two or more of the second cutting lanes 12 are disposed besides each first cutting lane 11. In other words, a cutting lane provided with the die test structure 30 is referred to as the first cutting lane 11, while a cutting lane extending in the same direction of the first cutting lane 11 but not provided with the die test structure 30 is referred to as the second cutting lane 12. In an example, one, two or more of the second cutting lanes 12 are disposed on one side (the side in the Y direction) of each first cutting lane 11, or the second cutting lanes 12 are disposed on both sides (sides in the Y direction) of each first cutting lane 11 and the numbers of the second cutting lanes 12 on either side may be equal or not equal.

In some implementations, the first cutting lane 11 and the second cutting lanes 12 may be arranged alternatively such that any one first cutting lane 11 is located between two second cutting lanes 12. That is, the first cutting lane 11 is adjacent to the two second cutting lanes 12. In other words, any one first cutting lane 11 is adjacent to a second cutting lane 12 on either side respectively.

In some implementations, at least three second cutting lanes 12 may be disposed between adjacent two first cutting lanes 11. As shown in Fig. 1, any one first cutting lane 11 is disposed adjacent to five second cutting lanes 12 and five second cutting lanes 12 are disposed between adjacent two first cutting lanes 11.

In some implementations, a plurality of cutting lanes 10 and a plurality of dies 20 may constitute a repeating unit C for mask exposure, which refers to the process of patterning the underlying structure via a mask, including photolithography process. The repeating unit C includes at least one first cutting lane 11 and the semiconductor device 100 includes a plurality of the repeating units C.

Fig. 1 shows one repeating unit C, which implies that the integrated circuit pattern in the semiconductor device 100 is obtained by repeating the repeating unit C in at least one of X direction or Y direction. It is appreciated that a first cutting lane 11 is also provided under the bottom die 20 in Fig. 1, but the first cutting lane 11 belongs to another repeating unit. It is also appreciated that the first cutting lane 11 at the lower part of Fig. 1 belongs to the repeating unit C while the first cutting lane 11 at the upper part of Fig. 1 belongs to another repeating unit. One repeating unit C may be formed by one mask, and 12 dies 20 shown in Fig. 1 may be formed with one mask.

As shown in Fig. 1, one repeating unit C may include one first cutting lane 11 and five second cutting lanes 12, and the first cutting lane 11 may be disposed on one side of the five second cutting lanes 12. In other implementations, the first cutting lane 11 may also be between any two second cutting lanes 12. It is to be noted that the numbers of cutting lanes 10 in the present disclosure are only examples, and the numbers of the cutting lanes 10, the first cutting lane 11 and the second cutting lanes 12 are not limited in the present disclosure.

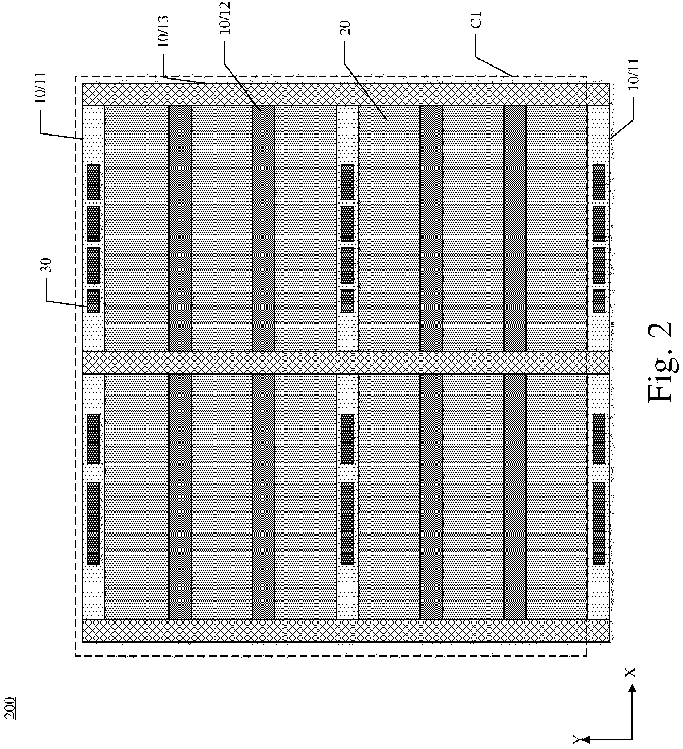

Referring to Fig. 2, Fig. 2 is a structure diagram of a semiconductor device provided by some implementations of the present disclosure. One repeating unit C1 is shown in the semiconductor device 200 in Fig. 2, and the repeating unit C1 includes two first cutting lanes 11 and four second cutting lanes 12. That is, in case there are many die test structures 30, the die test structures 30 may be concentrated in the two first cutting lanes 11.

In some implementations, in case there are many die test structures 30, the die test structures 30 may be concentrated in more than two first cutting lanes 11.

In some implementations, the number of second cutting lanes 12 spacing between two adjacent first cutting lanes 11 is equal, such that it can guarantee the distribution of die test structures 30 is uniform and the stress may be averaged. For example, there may be two second cutting lanes 12 between two adjacent first cutting lanes 11.

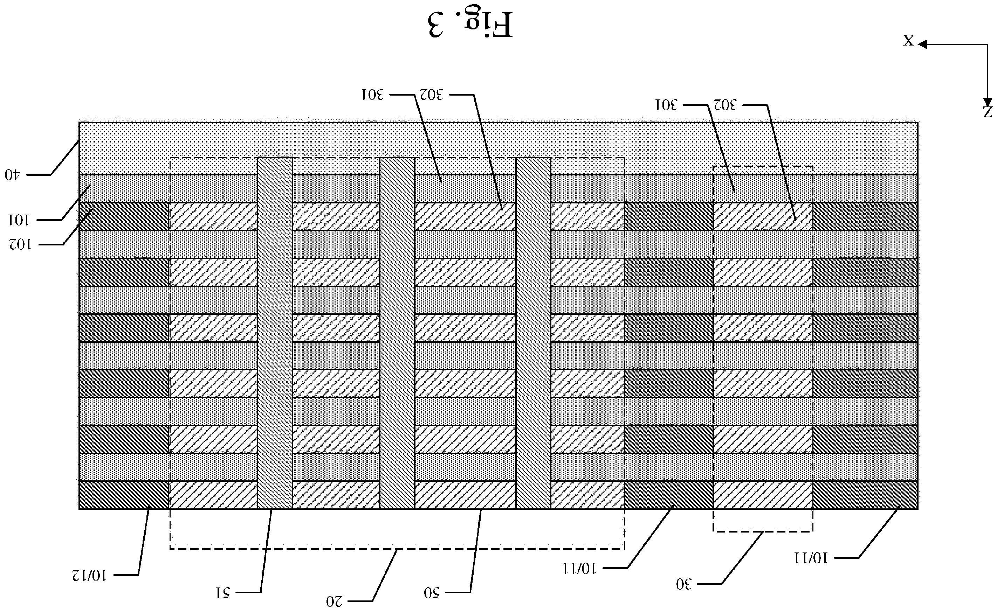

Referring to Fig. 3, Fig. 3 is a sectional structure diagram of the semiconductor device in Fig. 1 provided by some implementations of the present disclosure along A-A1.

The cutting lane 10 may include first dielectric layers 101 and second dielectric layers 102 stacked alternatively, and the die test structure 30 penetrates the cutting lane 10 in the stacking direction (Z) of the cutting lane 10 and may include third dielectric layers 301 and conductive layers 302 stacked alternatively in the stacking direction (Z).

The materials for the first dielectric layer 101 and the second dielectric layer 102 may include, but not limited to silicon oxide, silicon nitride or silicon oxynitride, and the materials for the first dielectric layer 101 and the second dielectric layer 102 are different. The material for the third dielectric layer 301 includes, but not limited to silicon oxide, silicon nitride or silicon oxynitride, of which the example material is silicon oxide. The third dielectric layer 301 may have the same material as the first dielectric layer 101 or the second dielectric layer 102. For example, both the third dielectric layers 301 and the first dielectric layers 101 are silicon oxide and are disposed on the same layer, and the conductive layer 302 and the second dielectric layer 102 are disposed on the same layer. Alternatively, both the third dielectric layer 301 and the second dielectric layer 102 are silicon oxide and disposed on the same layer, and the conductive layer 302 and the first dielectric layer 101 are disposed on the same layer.

The conductive layer 302 may include one or more conductive materials such as tungsten, titanium carbide, poly-crystalline silicon, etc. The conductive layers 302 may further include a high-k material such as aluminum oxide.

The semiconductor device 100 may further include a semiconductor layer 40 and a stack 50 on the semiconductor layer 40, and the stack 50 includes third dielectric layers 301 and conductive layers 302 stacked alternatively in the stacking direction (Z). The cutting lane 10 and the die test structure 30 are located on the semiconductor layer 40. A die 20 may include the stack 50 and some channel structures 51, and the die 20 (or the stack 50) is adjacent to the first cutting lane 11 and the second cutting lane 12.

In some implementations, the thickness of the cutting lane 10 may be equal to the thickness of the stack 50. It is appreciated that the "thickness" in the present disclosure refers to the thickness in Z direction.

In some implementations, the thickness of the die test structure 30 is smaller than or equal to the thickness of the cutting lane 10.

In some implementations, the thickness of each of all the die test structures 30 is smaller than the thickness of the cutting lane 10, or the thickness of each of all the die test structures 30 is equal to the thickness of the cutting lane 10.

In some implementations, the thickness of some die test structures 30 is smaller than the thickness of the cutting lane 10 and the thickness of other die test structures 30 is equal to the thickness of the cutting lane 10.

The die 20 may further include a memory device and a peripheral circuit (not shown in the figures) bonded with each other. Herein, the die 20 may be a memory (NAND) grain, and the peripheral circuit may be a CMOS (complementary metal oxide semiconductor). The peripheral circuit is electrically connected with the memory device to transfer signals with the memory device. The peripheral circuit may be configured to implement logical operations and control and detect on-off states of memory cells in the memory device via metal lines for data storing and reading.

The die test structure 30 may be configured for electric performance test of the memory device, the peripheral circuit or the bonding interface between the memory device and the peripheral circuit. For example, the die test structure 30 may be configured to test electric performance of memory cells in the memory device, test electric performance of transistors in the peripheral circuit, and test electrical connection of the bonding interface.

In some implementations, it is possible to separate the plurality of dies 20 to obtain a plurality of chips by cutting the semiconductor device 100 along the first cutting lane 11, the second cutting lanes 12 and the third cutting lane 13. Cutting processes may include laser cutting and mechanical cutting.

As found by the inventor through study, as the layers of the stack 50 become more and more, the number of conductive layers 302 in the die test structure 30 becomes greater and greater, that is, the thickness of the die test structure 30 becomes greater and greater. If the die test structures 30 are distributed in the first cutting lane 11 and the second cutting lane 12 scatteredly, they may also be distributed in the third cutting lane 13. If only one or two die test structures 30 are disposed in one cutting lane 10, then the cutting lane 10 has different materials at the location with the die test structure 30 and at the location without the die test structure 30. While laser scan cutting is performed along the cutting lane 10, since it is difficult to adjust the output power of the laser in scanning cutting of the same cutting lane 10, different depths are formed by cutting at different locations. In an example, the cutting depth at a location without the die test structure 30 is deeper than the cutting depth at a location with the die test structure 30. A too deep laser cutting depth would result in degraded strength of the device.

In the semiconductor device provided by implementations of the present disclosure, the die test structures 30 are concentrated in the first cutting lane 11 and there is no die test structure 30 in the second cutting lanes 12 and the third cutting lane 13, then it is possible to process the first cutting lane 11 with different laser settings while cutting with laser. For example, the laser energy for the second cutting lanes 12 and the third cutting lane 13 is adjusted such that it is smaller than the laser energy for the first cutting lane 11 (even 0), thereby achieving a better consistency of the laser cutting depth for the cutting lanes 10. That is, for the second cutting lanes 12 and the third cutting lane 13 without die test structure 30, it is possible to reduce their laser cutting depth to improve the degradation of the strength of device due to laser cutting. Further, the chip can undergo a greater bending force during the packaging process, thereby reducing the break risk of the chip.

In some implementations, the die test structures 30 are disposed in the first cutting lane 11 and not disposed at the intersection of the first cutting lane 11 and the third cutting lane 13 such that different cutting conditions may be used for the first cutting lane 11 and the third cutting lane 13 to achieve a better consistency of cutting depth.

In some implementations, it is possible to dispose the die test structures 30 with the same thickness in the same first cutting lane 11. For example, the die test structures 30 with a bigger thickness are disposed in one first cutting lane 11, and the die test structures 30 with a smaller thickness are disposed in another first cutting lane 11.

As compared to the first cutting lane 11 in which thicker die test structures 30 are disposed, the laser cutting condition for the first cutting lane 11 in which thinner die test structures 30 are disposed is adjusted such that the laser energy is smaller, which can achieve a better consistency of cutting depth for both of them. It is also possible to reduce the cutting depth of the first cutting lane 11 in which thinner die test structures 30 are disposed to improve the strength of device.

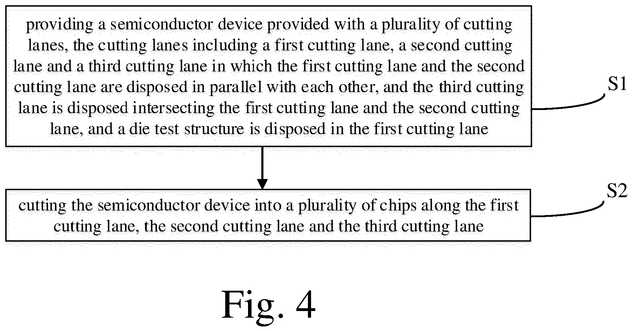

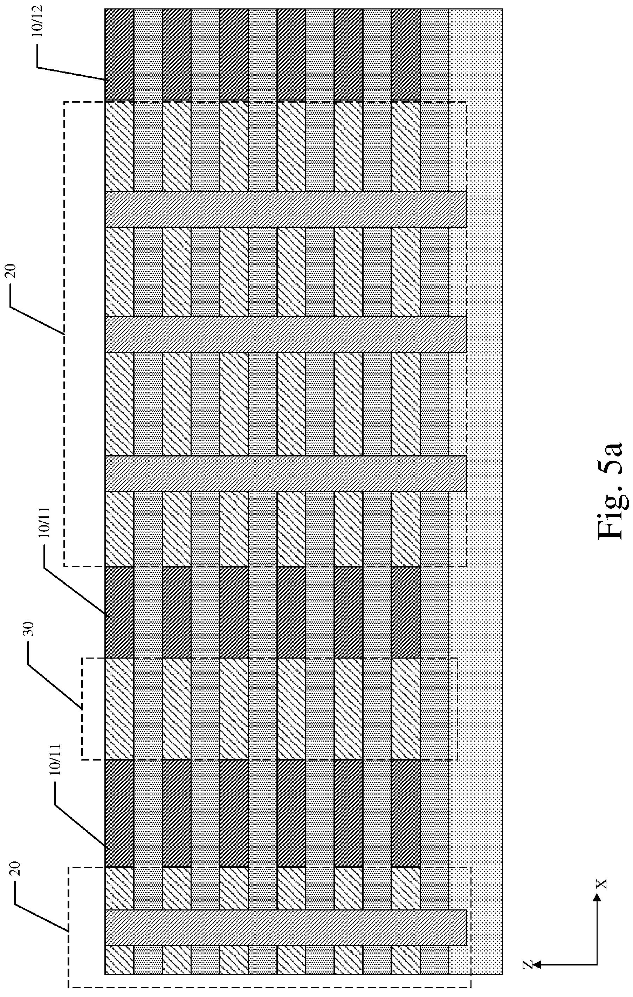

Referring to Fig. 4, Fig. 4 is a flow chart of a fabrication method of a chip provided by some implementations of the present disclosure. Referring to Figs. 5A-5c at the same time, Figs. 5a-5c are structure diagrams of a chip in the fabrication process provided by some implementations of the present disclosure. The chip is obtained by cutting the above-described semiconductor device 100, and thus Figs. 1 and 3 may be referred to. The fabrication of the chip may include the following operations S1-S2.

Operation S1: providing a semiconductor device provided with a plurality of cutting lanes 10, the cutting lanes 10 including a first cutting lane 11, a second cutting lane 12 and a third cutting lane 13 in which the first cutting lane 11 and the second cutting lane 12 are disposed in parallel with each other, and the third cutting lane 13 is disposed intersecting the first cutting lane 11 and the second cutting lane 12, and a die test structure 30 is disposed in the first cutting lane 11.

For example, referring to Fig. 1, in one repeating unit C, the die test structures 30 are concentrated in one first cutting lane 11. As shown in Fig. 5a, the die 20 is located between two first cutting lanes 11, or between the first cutting lane 11 and the second cutting lane 12.

Operation S2: cutting the semiconductor device into a plurality of chips 60 along the first cutting lane 11, the second cutting lane 12 and the third cutting lane 13.

In some implementations, it is possible to cut the semiconductor device twice with two different cutting processes. For example, a groove is formed on the front face of the device with laser cutting, and then the semiconductor device is completely cut with a machine such as a blade. Laser cutting may make the cutting edge on the front face of device smoother, thereby improving the quality of the front face of the chips 60.

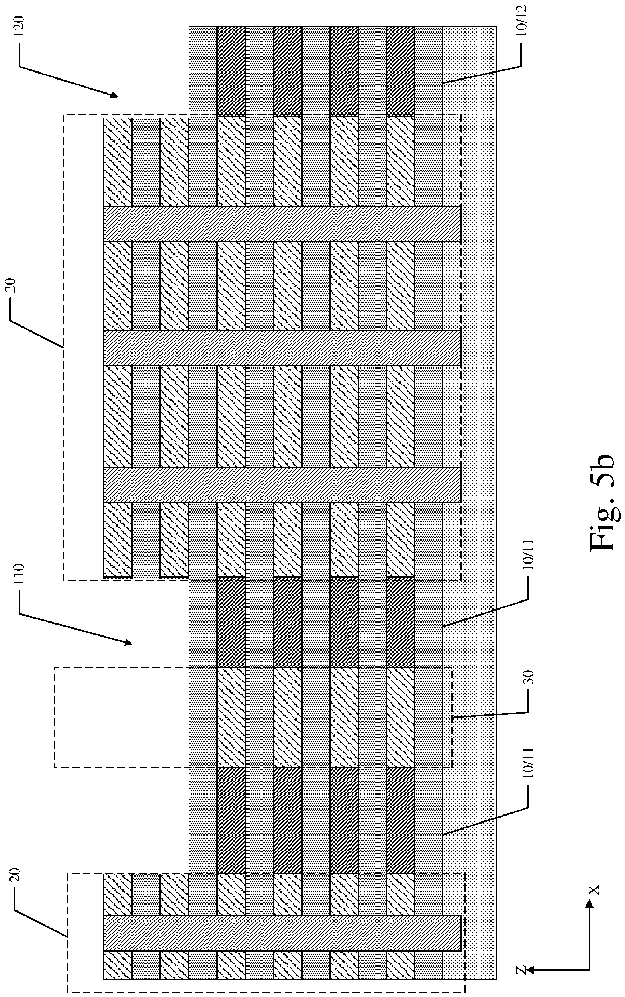

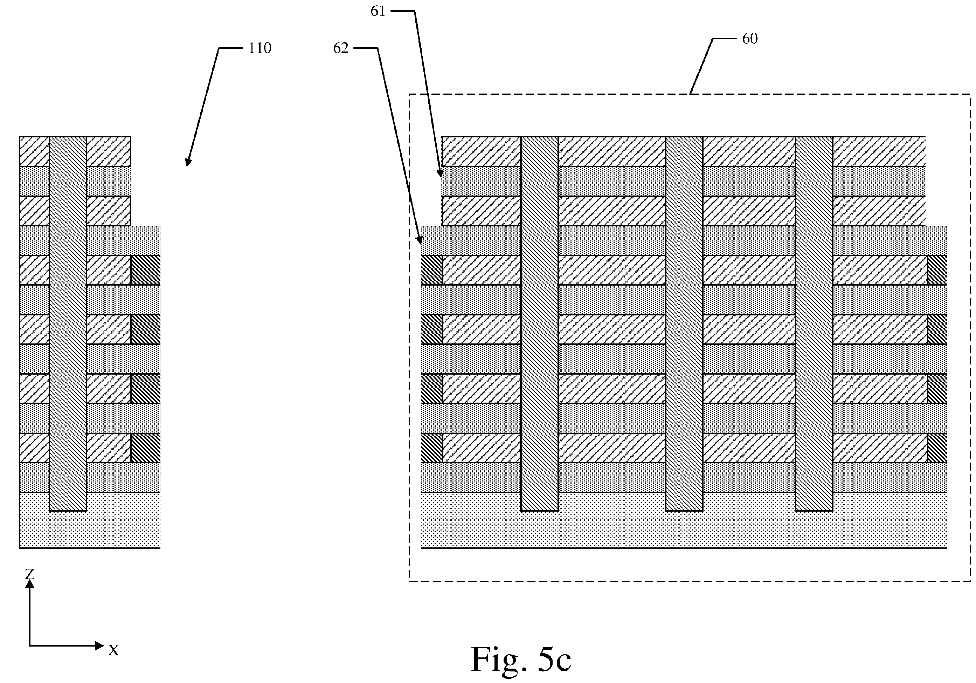

As shown in Fig. 5b, it is possible to form a first groove 110 in the first cutting lane 11 with a first laser to remove a part of the die test structure 30, wherein the depth of the first groove 110 is smaller than the thickness of the first cutting lane 11. As shown in Fig. 5c, then the second cutting lane 12, the third cutting lane 13, and the first cutting lane 11 under the first groove 110 are cut mechanically to form a plurality of chips 60. That is, the first cutting lane 11 may be cut once with laser to form the groove, while the second cutting lane 12 and the third cutting lane 13 are not cut with laser, and then the first cutting lane 11, the second cutting lane 12 and the third cutting lane 13 are cut mechanically once to cut the semiconductor device into a plurality of chips 60. Therefore, such cutting manner can realize local laser cutting and low-cost high output.

In some implementations, it is also possible to form a second groove 120 in the second cutting lane 12 with a second laser and form a third groove (not shown) in the third cutting lane 13 before performing the described-above mechanical cutting, wherein the depth of the second groove 120 is smaller than the thickness of the second cutting lane 12, and the depth of the third groove is smaller than the thickness of the third cutting lane 13.

Since there is no the die test structure 30 in the second cutting lane 12 and the third cutting lane 13, setting the energy of the second laser to be smaller than the energy of the first laser may allow the depth of the second groove 120 and the third groove to be consistent with the depth of the first groove 110. That is, in the case of laser cutting, the laser cutting depth of the second cutting lane 12 and the third cutting lane 13 is reduced to improve the strength of the chips 60.

In some implementations, it is also possible to reduce the number of burnings with the second laser (smaller than the number of burnings with the first laser) such that the depth of the second groove 120 and the third groove to be consistent with the depth of the first groove 110. In case that the second cutting lane 12 and the third cutting lane 13 are not cut with laser, or the number of burnings with laser is small, it is possible to reduce the laser burning time required for the entire semiconductor device and improve the unit time output.

It is appreciated that as shown in Fig. 1, since the die test structures 30 do not cover the first cutting lane 11 completely, there are intervals between the die test structures 30, therefore the cutting depth in the die test structures 30 will be smaller than the laser cutting depth at the intervals while cutting the first cutting lane 11 with laser scanning.

With the fabrication method of chips provided by implementations of the present disclosure, since the die test structures 30 are concentrated in the first cutting lane 11, it is possible to use different parameters for the first cutting lane 11 than the second cutting lane 12 and the third cutting lane 13 to reduce the laser cutting depth of the second cutting lane 12 and the third cutting lane 13, thereby improving strength of chips 60.

An implementation of the present disclosure further provides a chip fabricated from the semiconductor device of any one of the above-described implementations. Referring to Fig. 5c, the chip includes a first cutting face 61 and a second cutting face 62 outside the first cutting face 61, and the second cutting face 62 has a height in Z direction smaller than the height of the first cutting face 61 in Z direction.

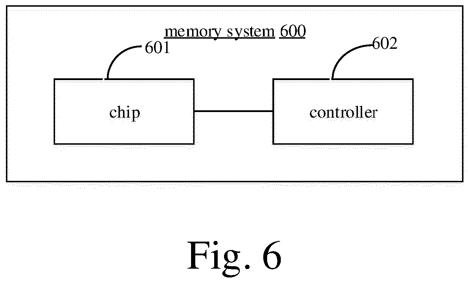

Referring to Fig. 6, Fig. 6 is a structure diagram of a memory system provided in some implementations of the present disclosure. The memory system 600 includes a chip 601 and a controller 602. The chip 601 may be the chip in any of the above-described implementations and may be fabricated from the semiconductor device in the above-described implementations. The controller 602 is electrically connected with the chip 601 to control the chip 601 to store data and the chip 601 may execute data storage operations based on the controller's 602 control.

In some implementations, the memory system may be implemented as multimedia card such as universal flash storage (UFS) device, solid state hard disk (SSD), MMC, eMMC, RS-MMC and mini-MMC, secure digital card such as SD, mini-SD and micro-SD, storage device of Personal Computer Memory Card International Association (PCMCIA) type, storage device of peripheral component interconnect (PCI) type, storage device of PCI Express (PCI-E) type, compact flash (CF) card, smart media card or memory stick etc.

Description of the implementations above is only used to facilitate understanding of the technical solutions and the core concept of the present disclosure. It can be understood by those of ordinary skills in the art that the technical solutions described in the foregoing various implementations can be modified or have some technical features therein replaced equivalently without departing from the spirit and scope of the technical solutions in the implementations of the present disclosure.

## Claims

1. A semiconductor device comprising:
a plurality of cutting lanes, comprising at least one first cutting lane, a plurality of second cutting lanes and a third cutting lane, wherein the first cutting lane and the second cutting lanes are disposed in parallel with each other, and the third cutting lane is disposed intersecting the first cutting lane and the second cutting lanes;
a plurality of dies defined by the intersection of the plurality of cutting lanes; and
a die test structure only located in the first cutting lane, wherein any one first cutting lane is disposed at least adjacent to one of the second cutting lanes.

2. The semiconductor device of claim 1, wherein at least three of the second cutting lanes are arranged between adjacent two of the first cutting lanes.

3. The semiconductor device of claim 1, wherein a number of the second cutting lanes spaced between the adjacent two of the first cutting lanes is equal.

4. The semiconductor device of claim 1, wherein the cutting lane comprises first dielectric layers and second dielectric layers stacked alternatively, and the die test structure penetrates the cutting lanes in a stacking direction of the cutting lanes and comprises third dielectric layers and conductive layers stacked alternatively in the stacking direction.

5. The semiconductor device of claim 4, wherein a thickness of the die test structure is smaller than or equal to a thickness of the cutting lane.

6. The semiconductor device of claim 5, wherein the die test structures with a same thickness are located in the same first cutting lane.

7. The semiconductor device of claim 4, further comprising:
a semiconductor layer;
a stack on the semiconductor layer and comprising the third dielectric layers and the conductive layers stacked alternatively in the stacking direction;
wherein the cutting lanes and the die test structure are located on the semiconductor layer.

8. The semiconductor device of claim 1, wherein the die comprises a memory device and a peripheral circuit bonded with each other, and the die test structure is configured for electric performance test of the memory device, the peripheral circuit or a bonding interface between the memory device and the peripheral circuit.

9. The semiconductor device of claim 1, wherein the plurality of cutting lanes and the plurality of dies constitute a repeating unit, and the repeating unit comprises the at least one first cutting lane and the semiconductor device comprises a plurality of the repeating units.

10. A chip fabricated from the semiconductor device of any one of claims 1-9, wherein the chip comprises a first cutting face and a second cutting face outside the first cutting face, and the second cutting face has a height smaller than a height of the first cutting face.

11. A memory system comprising:
the chip of claim 10; and
a controller electrically connected with the chip to control the chip to store data.

12. A fabrication method of a chip, comprising:
providing a semiconductor device provided with a plurality of cutting lanes, the cutting lanes comprising a first cutting lane, a second cutting lane and a third cutting lane, wherein the first cutting lane and the second cutting lane are disposed in parallel with each other, and the third cutting lane is disposed intersecting the first cutting lane and the second cutting lane, and a die test structure is disposed in the first cutting lane; and
cutting the semiconductor device into a plurality of chips along the first cutting lane, the second cutting lane and the third cutting lane.

13. The fabrication method of the chip of claim 12, wherein the cutting the semiconductor device into a plurality of chips along the first cutting lane, the second cutting lane and the third cutting lane comprises:
cutting the semiconductor device twice with two different cutting processes, respectively.

14. The fabrication method of the chip of claim 13, wherein the cutting the semiconductor device into a plurality of chips along the first cutting lane, the second cutting lane and the third cutting lane comprises:
forming a first groove in the first cutting lane with a first laser to remove a part of the die test structure, wherein a depth of the first groove is smaller than a thickness of the first cutting lane; and
cutting mechanically the second cutting lane, the third cutting lane and the first cutting lane under the first groove to form a plurality of chips.

15. The fabrication method of the chip of claim 14, wherein before cutting the first cutting lane under the first groove, the second cutting lane and the third cutting lane with a blade, the fabrication method of the chip further comprises:
forming a second groove in the second cutting lane and forming a third groove in the third cutting lane with a second laser, wherein a depth of the second groove is smaller than a thickness of the second cutting lane, and a depth of the third groove is smaller than a thickness of the third cutting lane;
the cutting mechanically the second cutting lane, the third cutting lane and the first cutting lane under the first groove comprises: cutting the first cutting lane under the first groove, the second cutting lane under the second groove and the third cutting lane under the third groove with the blade.

16. The fabrication method of the chip of claim 15, wherein an energy of the second laser is smaller than an energy of the first laser.
